# EUROPÄISCHE PATENTSCHRIFT

(11) **EP 1 807 872 B1**
(45) Veröffentlichungstag und Bekanntmachung des Hinweises auf die Patenterteilung: **18.04.2012**
(21) Anmeldenummer: 05798238.1
(22) Anmeldetag: 26.10.2005
(51) Int. Cl.: H01L 31/032, H01L 31/0296, C30B 29/48

(54) **PHOTOVOLTAISCHE ZELLE MIT EINEM PHOTOVOLTAISCH AKTIVEN HALBLEITERMATERIAL**
PHOTOVOLTAIC CELL COMPRISING A PHOTOVOLTAIC ACTIVE SEMICONDUCTOR MATERIAL
PILE PHOTOVOLTAIQUE CONTENANT UNE MATIERE SEMI-CONDUCTRICE A ACTION PHOTOVOLTAIQUE

(30) Priorität: 26.10.2004 DE 102004052012
(43) Veröffentlichungstag der Anmeldung: 18.07.2007
(73) Patentinhaber: BASF SE, 67056 Ludwigshafen (DE)
(72) Erfinder: STERZEL, Hans-Josef, 67125 Dannstadt-Schauernheim (DE)
(86) Internationale Anmeldenummer: PCT/EP2005/011461
(87) Internationale Veröffentlichungsnummer: WO 2006/045600

(56) Entgegenhaltungen:
- EP-A- 0 708 488
- EP-A- 1 388 597
- TAO I W ET AL: "DOPING OF ZNTE BY MOLECULAR BEAM EPITAXY" APPLIED PHYSICS LETTERS, AIP, AMERICAN INSTITUTE OF PHYSICS, MELVILLE, NY, US, Bd. 64, Nr. 14, 4. April 1994 (1994-04-04), Seiten 1848-1849, XP000440900 ISSN: 0003-6951
- G.A. IL'CHUK ET AL.: SEMICONDUCTORS, Bd. 34, Nr. 11, 2000, Seiten 1275-1280, XP009061520

## Beschreibung

Die Erfindung betrifft photovoltaische Zellen und das darin enthaltene photovoltaisch aktive Halbleitermaterial.

Photovoltaisch aktive Materialien sind Halbleiter, welche Licht in elektrische Energie umsetzen. Die Grundlagen hierzu sind lange bekannt und werden technisch genutzt. Nahezu die meisten der technisch genutzten Solarzellen basieren auf kristallinem Silizium (ein- oder polykristallin). In einer Grenzschicht zwischen p- und n-leitendem Silizium regen einfallende Photonen Elektronen des Halbleiters an, so dass sie vom Valenzband in das Leitungsband gehoben werden.

Die Höhe der Energielücke zwischen dem Valenzband und dem Leitungsband limitiert den maximal möglichen Wirkungsgrad der Solarzelle. Beim Silizium ist dies circa 30% bei Bestrahlung mit Sonnenlicht. In der Praxis erreicht man dagegen einen Wirkungsgrad von circa 15%, weil ein Teil der Ladungsträger durch verschiedene Prozesse rekombiniert und so der Nutzung entzogen wird.

Aus DE 102 23 744 A1 sind alternative photovoltaisch aktive Materialien und diese enthaltende Photovoltaikzellen bekannt, die den Wirkungsgrad herabsetzende Verlustmechanismen in einem verringerten Maße aufweisen.

Mit einer Energielücke um 1,1 eV weist Silizium einen für die Nutzung recht guten Wert auf. Durch ein Verkleinern der Energielücke werden zwar mehr Ladungsträger ins Leitungsband befördert, die Zellspannung wird jedoch niedriger. Entsprechend werden bei größeren Energielücken zwar höhere Zellspannungen erreicht, da aber weniger Photonen zur Anregung vorhanden sind, stehen niedrigere nutzbare Ströme zur Verfügung.

Viele Anordnungen wie die Serienanordnung von Halbleitern mit verschiedenen Energielücken, in so genannten Tandemzellen wurden vorgeschlagen, um höhere Wirkungsgrade zu erreichen. Diese sind wegen ihres komplexen Aufbaus jedoch wirtschaftlich kaum zu realisieren.

Ein neues Konzept besteht darin, innerhalb der Energielücke ein Zwischenniveau zu generieren (Up-Conversion). Dieses Konzept ist beispielsweise beschrieben in Proceedings of the 14th Workshop on Quantum Solar Energy Conversion-Quantasol 2002, March, 17-23, 2002, Rauris, Salzburg, Österreich, "Improving solar cells efficiencies by the up-conversion", Tl. Trupke, M.A. Green, P. Würfel oder "Increasing the Efficiency of Ideal Solar Cells by Photon Induced Tranisitions at intermediate Levels", A. Luque and A. Marti, Phys. Rev. Letters, Vol. 78, Nr. 26, June 1997, 5014-5017. Für eine Bandlücke von 1,995 eV und eine Energie des Zwischenniveaus bei 0,713 eV ergibt sich rechnerisch ein maximaler Wirkungsgrad von 63,17%.

Spektroskopisch wurden derartige Zwischenniveaus beispielsweise am System Cd_{1-y}Mn_{y}OₓTe₁₋ₓ oder an Zn₁₋ₓMnₓO_{y}Te_{1-y} nachgewiesen. Dies ist beschrieben in "Band anticrossing in group II-OxVI1-x highly mismatched alloys: Cd1-yMnyOxTe1-x quaternaries synthesized by O ion implantation", W. Walukiewicz et al., Appl. Phys. Letters, Vol 80, Nr. 9, March 2002, 1571-1573 und in "Synthesis and optical properties of II-O-VI highly mismatched alloys", W. Walukiewicz et al., J. Appl. Phys. Vol. 95, Nr. 11, June 2004, 6232-6238. Demnach wird das erwünschte energetische Zwischenniveau in der Bandlücke dadurch erhöht, dass im Anionengitter ein Teil der Telluranionen durch das wesentlich elektronegativere Sauerstoffion ersetzt wird. Dabei wurde Tellur durch Ionenimplantation in dünnen Filmen durch Sauerstoff ersetzt. Ein wesentlicher Nachteil dieser Stoffklasse besteht darin, dass die Löslichkeit des Sauerstoffs im Halbleiter äußerst gering ist. Daraus folgt, dass beispielsweise die Verbindungen Zn₁₋ₓMnₓTe_{1-y}O_{y} mit y größer als 0,001 thermodynamisch nicht stabil sind. Bei Bestrahlung über längere Zeit verfallen sie in die stabilen Telluride und Oxide. Ein Einsatz von bis zu 10 At-% Tellur durch Sauerstoff wäre erwünscht, wobei solche Verbindungen jedoch nicht stabil sind.

Zinktellurid, das bei Raumtemperatur eine direkte Bandlücke von 2,32 eV aufweist, wäre wegen dieser großen Bandlücke ein idealer Halbleiter für die Zwischenniveautechnologie. Zink lässt sich gut in Zinktellurid kontinuierlich durch Mangan substituieren, wobei die Bandlücke auf circa 2,8 eV bei MnTe anwächst ("Optical Properties of epitaxial Zn Mn Te and ZnMgTe films for a wide range of alloy compostions", X. Liu et al., J. Appl. Phys. Vol. 91, Nr. 5, March 2002, 2859-2865; "Bandgap of Zn1-xMnxTe: non linear dependence on compostion and temperature", H.C. Mertins et al., Semicond. Sci. Technol. 8 (1993) 1634-1638).

Zn₁₋ₓMnₓTe lässt sich mit bis zu 0,2 Mol-% Phosphor p-leitend dotieren, wobei eine elektrische Leitfähigkeit zwischen 10 und 30 Ω⁻¹cm⁻¹ erreicht wird ("Electrical and Magnetic Properties of Phosphorus Doped Bulk Zn1-xMnxTe", Le Van Khoi et al., Moldavian Journal of Physical Sciences, Nr. 1, 2002, 11-14). Durch partielles Ersetzen von Zink durch Aluminium werden n-leitende Spezies erhalten ("Aluminium-doped n-type ZnTe layers grown by molecular-beam epitaxy", J.H. Chang et al., Appl. Phys. Letters, Vol 79, Nr. 6, august 2001, 785-787; "Aluminium doping of ZnTe grown by MOPVE", S.I. Gheyas et al., Appl. Surface Science 100/101 (1996) 634-638; "Electrical Transport and Photoelectronic Properties of ZnTe: A1 Crystals", T.L. Lavsen et al., J. Appl. Phys., Vol 43, Nr. 1, Jan 1972, 172-182). Mit Dotierungsgraden um 4*10¹⁸ Al/cm³ können elektrische Leitfähigkeiten um 50 bis 60 Ω⁻¹cm⁻¹ erreicht werden.

Die Aufgabe der vorliegenden Erfindung besteht darin, eine photovoltaische Zelle mit einem hohen Wirkungsgrad und einer hohen elektrischen Leistung bereitzustellen, die die Nachteile des Standes der Technik vermeidet. Weiterhin ist es Aufgabe der vorliegenden Erfindung insbesondere eine photovoltaische Zelle mit einem thermodynamisch stabilen photovoltaisch aktiven Halbleitermaterial bereitzustellen, wobei das Halbleitermaterial ein Zwischenniveau in der Energielücke enthält.

Diese Aufgabe wird erfindungsgemäß gelöst durch eine photovoltaische Zelle mit einem photovoltaisch aktiven Halbleitermaterial, wobei das photovoltaisch aktive Halbleitermaterial ein p- oder n-dotiertes Halbleitermaterial mit einer binären Verbindung der Formel (I) oder mit einer ternären Verbindung der Formel (II) ist:

ZnTe (I)

Zn₁₋ₓMnₓTe (II)

mit x = Zahl von 0,01 bis 0,99, wobei in dem photovoltaisch aktiven Halbleitermaterial zu einem bestimmten Anteil Tellurionen durch Halogenione und Stickstoffionen substituiert sind und die Halogenionen ausgewählt sind aus der Gruppe bestehend aus Fluorid, Chlorid und Bromid oder einer Mischung daraus.

In ZnTe oder Zn₁₋ₓMnₓTe lässt sich das Tellurion nicht einfach gegen ein Halogenion austauschen. Halogenionen sind einfach negativ geladen. Ein zweifach negativ geladenes Tellurion wäre daher durch zwei Halogenionen zu ersetzen, was bei hohen Dotierkonzentrationen nicht möglich ist. Deshalb besteht die Lösung der Erfindung darin, Tellurionen durch Halogenionen sowie dreifach negativ geladene Stickstoffionen zu ersetzen. Mit einem Radius von 1,71 Å von N³⁻ kann Te²⁻ durch N³⁻ ersetzt werden, wobei die Differenz der Elektronegativität zu Te²⁻ 0,94 beträgt. Das Molverhältnis von Halogenen und Stickstoff kann 1:1 betragen. Überraschenderweise sind auch andere Molverhältnisse von Halogenen zu Stickstoff möglich.

Manganhaltige Legierungen lagern leicht Stickstoff als N³⁻ ein, so dass sich die erfindungsgemäße Lösung u.a. auf ternäre Halbleiter des Typs Zn₁₋ₓMnₓTe mit x = 0,01 bis 0,09 bezieht.

Die erfindungsgemäße photovoltaische Zelle hat den Vorteil, dass das verwendete photovoltaisch aktive Halbleitermaterial auch nach dem Substituieren von Tellur durch Halogen und Stickstoff (überraschenderweise nicht nur in einem Molverhältnis von Halogen zu Stickstoff von 1:1) thermodynamisch stabil ist. Ferner weist die erfindungsgemäße photovoltaische Zelle einen hohen Wirkungsgrad (ggf. >20%) auf, da durch die Substitution der Tellurionen durch Halogenionen und Stickstoffionen ein Zwischenniveau in der Energielücke des photovoltaisch aktiven Halbleitermaterials erzeugt wird. Ohne Zwischenniveau können nur solche Photonen Elektronen oder Ladungsträger vom Valenzband in das Leitungsband heben, die mindestens die Energie der Energielücke aufweisen. Photonen höherer Energie tragen auch zum Wirkungsgrad bei, wobei der Überschuss an Energie bzgl. der Bandlücke als Wärme verloren geht. Mit dem Zwischenniveau, das bei dem für die vorliegende Erfindung verwendeten Halbleitermaterial vorhanden ist und das teilweise besetzt werden kann, können mehr Photonen zur Anregung beitragen.

Die erfindungsgemäße photovoltaische Zelle ist so aufgebaut, dass sie ein p-dotiertes und ein n-dotiertes Halbleitermaterial enthält, wobei diese beiden Halbleitermaterialien aneinander grenzen, um einen p-n-Übergang zu bilden. Dabei besteht sowohl das p- als auch das n-dotierte Halbleitermaterial weitgehend aus der binären Verbindung der Formel (I) oder einer ternären Verbindung der Formel (II), wobei ein Teil der Tellurionen durch Halogen- und Stickstoffionen substituiert ist und das Material ferner mit Donatorionen in dem p-dotierten Halbleitermaterial und Akzeptorionen in dem n-dotierten Halbleitermaterial dotiert ist. Dabei kann das p-dotierte Halbleitermaterial andere Halogenionen oder Halogenionmischungen enthalten als das n-dotierte Halbleitermaterial.

Bei der vorliegenden Erfindung enthält das photovoltaisch aktive Halbleitermaterial als Halogenionen Fluorid, Chlorid oder Bromid oder eine Mischung daraus. Es werden also in dem Halbleitermaterial mit der binären Verbindung nach Formel (I) oder einer ternären Verbindung nach Formel (II) teilweise Tellurionen durch Fluor-, Chlor- oder Bromionen und Stickstoffionen substituiert. Diese drei Halogenionsorten weisen einen für die Substition vorteilhaften Ionenradius auf. Tellurionen haben einen Ionenradius von 2,11 Å,Fluoridionen von 1,33 Å, Chloridionen von 1,81 Å und Bromidionen von 1,96 Å. Die Differenz der Elektronegativität nach Pauling zu der Elektronegativität von Tellur (2,1) beträgt bei Fluoridionen 1,88, bei Chloridionen 1,06 und bei Bromidionen 0,86.

Gemäß einer bevorzugten Ausführungsform der vorliegenden Erfindung sind in dem photovoltaisch aktiven Halbleitermaterial Stickstoff und Halogene jeweils mit einem Atomkonzentrationsanteil von 0,1 At-% bis 20 At-%, bevorzugt 0,2 At-% bis 10 At-% enthalten. Bei diesem Atomkonzentrationsanteil von Stickstoff und einem Halogen oder einer Mischung von Halogenen liegt in vorteilhafter Weise ein Zwischenniveau in der Energielücke des photovoltaisch aktiven Halbleitermaterials vor, das eine Steigerung des Wirkungsgrades der erfindungsgemäßen photovoltaischen Zelle ermöglicht.

Vorzugsweise enthält das p-dotierte Halbleitermaterial mindestens ein Element aus der Gruppe As und P mit einem Atomkonzentrationsanteil von bis zu 0,5 At-% und das n-dotierte Halbleitermaterial mindestens ein Element aus der Gruppe Al, In und Ga mit einem Atomkonzentrationsanteil von bis zu 0,5 At-%. Bevorzugte Dotierelemente sind Aluminium und Phosphor.

Gemäß einer bevorzugten Ausführungsform der erfindungsgemäßen photovoltaischen Zelle umfasst diese ein elektrisch leitfähiges Substrat, eine p-Schicht aus dem p-dotierten Halbleitermaterial mit einer Dicke von 0,1 bis 10 µm, bevorzugt 0,3 bis 3 µm und eine n-Schicht aus dem n-dotierten Halbleitermaterial mit einer Dicke von 0,1 bis 10 µm, bevorzugt 0,3 bis 3 µm. Vorzugsweise ist das Substrat eine flexible Metallfolie oder ein flexibles Metallblech. Durch die Kombination aus einem flexiblen Substrat mit dünnen photovoltaisch aktiven Schichten ergibt sich der Vorteil, dass keine aufwendigen und damit teuren Auflager zur Halterung der die erfindungsgemäßen photovoltaischen Zellen enthaltenden Solarmodule eingesetzt werden müssen. Bei unflexiblen Substraten wie Glas oder Silizium müssen Windkräfte durch aufwendige Tragekonstruktionen abgefangen werden, um ein Brechen der Solarmodule zu vermeiden. Ist dagegen eine Verwindung durch Flexibilität möglich, so können sehr einfache und preiswerte Tragkonstruktionen eingesetzt werden, die nicht verwindungssteif sein müssen. Als bevorzugtes flexibles Substrat wird bei der vorliegenden Erfindung insbesondere ein Edelstahlblech verwendet.

Gemäß einer bevorzugten Ausführungsform der vorliegenden Erfindung hat das in der n-Schicht enthaltene n-dotierte Halbleitermaterial eine Zusammensetzung gemäß (III) oder (IV):

ZnTe_{1-2y}Hal_{y}N_{y} (III)

Zn₁₋ₓMnₓTe_{1-2y}Hal_{y}N_{y} (IV)

mit x = 0,01 bis 0,99 und y = 0,01 bis 0,2,
und ist mit Phosphor, Arsen oder einer Mischung daraus dotiert und das in der p-Schicht enthaltene p-dotierte Halbleitermaterial hat eine Zusammensetzung gemäß Formel (V) oder (VI):

ZnTe_{1-2y}Hal_{y}N_{y} (V)

Zn₁₋ₓMnₓTe_{1-2y}Hal_{y}N_{y} (VI)

mit x = 0,01 bis 0,99 und y = 0,01 bis 0,2,
und ist mit Aluminium, Indium, Gallium oder einer Mischung daraus dotiert.

Die Erfindung bezieht sich weiterhin auf ein Verfahren zur Herstellung einer erfindungsgemäßen photovoltaischen Zelle umfassend das Beschichten eines elektrisch leitfähigen Substrats mit mindestens zwei Schichten aus dem p- oder n-dotierten Halbleitermaterial mit der Verbindung nach Formel (I) oder (II), wobei jede Schicht eine Dicke von 0,1 bis 10 µm, vorzugsweise von 0,3 bis 3 µm aufweist. Erfindungsgemäß werden also mindestens je eine dünne Schicht des p- und des n-dotierten Halbleitermaterials auf dem elektrisch leitfähigen Substrat erzeugt.

Das Beschichten des Substrats mit der p- oder n-Schicht umfasst dabei vorzugsweise mindestens ein Abscheidungsverfahren ausgewählt aus der Gruppe Sputtern, elektrochemisches Abscheiden oder stromloses Abscheiden. Durch das jeweilige Abscheidungsverfahren kann das bereits p- oder n-dotierte Halbleitermaterial mit der binären Verbindung der Formel (I) oder der ternären Verbindung der Formel (II) als Schicht auf das Substrat aufgebracht werden. Alternativ dazu kann eine Schicht aus dem Halbleitermaterial zunächst ohne p- oder n-Dotierung durch das Abscheidungsverfahren erzeugt werden und diese Schicht anschließend p- oder n-dotiert werden. Die erfindungsgemäße teilweise Substitution von Tellurionen durch Halogenionen und Stickstoffionen in dem Halbleitermaterial wird (falls die jeweilige durch eines der oben genannten Abscheidungsverfahren hergestellte Schicht noch nicht entsprechend ausgebildet ist) vorzugsweise im Anschluss an die Durchführung des Abscheidungsverfahrens (und gegebenenfalls an die p- oder n-Dotierung) durchgeführt.

Ein mögliches Abscheidungsverfahren ist das Beschichten durch Sputtern. Sputtern bezeichnet das Herausschlagen von Atomen aus einem als Elektrode dienenden Sputtertarget durch beschleunigte Ionen und die Deposition des herausgeschlagenen Materials auf einem Substrat. Zum Beschichten eines Substrats bei der vorliegenden Erfindung werden zum Sputtern z.B. Sputtertargets aus Zn₁₋ₓMnₓTe:Al und Zn₁₋ₓMnₓTe:P verwendet oder einzelne Bestandteile des Halbleitermaterials werden nacheinander auf das Substrat gesputtert und anschließend auf eine Temperatur von 400 bis 900°C erwärmt.

Bei der Verwendung eines durch Zusammenschmelzen der Bestandteile hergestellten Sputtertargets z.B. mit der Zusammensetzung Zn₁₋ₓMnₓTe:Al oder Zn₁₋ₓMnₓTe:P wird bei dem Sputterprozess eine bereits dotierte Halbleiterschicht erzeugt. Die nach dem Doppelpunkt genannten Elemente sind dabei die Dotierelemente. Die so hergestellte Schicht wird anschließend mit Halogen(en) und Stickstoff dotiert.

Es ist ferner möglich, die Bestandteile Zn, Mn, Te sowie A1 oder P nacheinander durch Sputtern auf das Substrat aufzubringen und die so erzeugten Schichten danach auf Temperaturen von 400 bis 900°C zu erhitzen, um so eine thermodynamisch stabile Zusammensetzung herzustellen. Diese bildet sich aus den Einzelkomponenten einer Festkörperreaktion auf dem Substrat.

Des Weiteren kann ein Sputtertarget mit der Zusammensetzung ZnTe oder Zn₁₋ₓMnₓTe verwendet werden oder die Bestandteile Zn, Te und ggf. Mn nacheinander durch Sputtern als Schicht auf das Substrat aufgebracht werden. In diesen Fällen erfolgt sowohl das p- oder n-Dotieren als auch das Substituieren durch Halogen und Stickstoff in einem separaten Herstellungsschritt der erfindungsgemäßen photovoltaischen Zelle.

Ein weiteres bevorzugtes erfindungsgemäßes Abscheidungsverfahren ist das elektrochemische Abscheiden z.B. von Zn₁₋ₓMnₓTe auf dem elektrisch leitfähigen Substrat. Die elektrochemische Abscheidung von ZnTe ist beschrieben in "Thin films of ZnTe electrodeposited on stainless steel", A.E. Rakhsan u. B. Pradup, Appl. Phys. A (2003), Pub online Dec. 19, 2003, Springer-Verlag; "Electrodeposition of ZnTe for photovoltaic alls", B. Bozzini et al., Thin Solid Films, 361-362, (2000) 288-295; "Electrochemical deposition of ZnTe Thins films", T. Mahalingam et al., Semicond. Sci. Technol. 17 (2002) 469-470; "Electrodeposition of Zn-Te Semiconductor Film from Acidic Aqueous Solution", R. Ichino et al., Second Internat. Conference on Processing Materials for Properties, The Minerals, Metals & Materials Society, 2000 und in US-PS 4,950,615, nicht hingegen die elektrochemische Abscheidung von gemischten Zn/Mn/Te-Schichten.

Gegenstand eines erfindungsgemäßen Verfahrens ist es ferner, Zn₁₋ₓMnₓTe-Schichten stromlos abzuscheiden, indem in Gegenwart des Substrats eine wässrige Lösung, die Zn²⁺, Mn²⁺ sowie TeO₃²⁻-Ionen enthält, bei Temperaturen von 30 bis 90°C mit hypophosphoriger Säure (H₃PO₂) als Reduktionsmittel vernetzt wird. Durch die hypophosphorige Säure wird TeO₃²⁻ zu Te²⁻ reduziert. Damit sind auch Abscheidungen auf elektrisch nicht leitenden Substraten möglich.

Je nach Abscheidungsverfahren sind noch Nachbehandlungen notwendig, um Halogenide und Stickstoff in die Schichten einzubauen, teilweise auch um die Dotierstoffe einzubringen.

Gemäß einer bevorzugten Ausführungsform der vorliegenden Erfindung weist das erfindungsgemäße Verfahren folgende Verfahrensschritte auf:
a) Beschichten des elektrisch leitfähigen Substrats mit einer ersten Schicht aus ZnTe oder Zn₁₋ₓMnₓTe,
b) Dotieren der ersten Schicht mit Halogenionen und Stickstoffionen,
c) Erzeugen einer p- oder einer n-Dotierung durch Dotieren mit Donatoratomen oder Akzeptoratomen,
d) Beschichten der ersten Schicht mit einer zweiten Schicht aus ZnTe oder Zn₁₋ₓMnₓTe,
e) Dotieren der zweiten Schicht mit Halogenionen und Stickstoffionen,
f) Erzeugen einer n- oder p-Dotierung durch Dotieren mit Akzeptoratomen oder Donatoratomen und
g) Aufbringen einer elektrisch leitfähigen transparenten Schicht und einer Schutzschicht auf die zweite Schicht.

In Schritt a) wird das elektrisch leitfähige Substrat zum Beispiel durch Sputtern, elektrochemische Abscheidung oder stromlose Abscheidung mit einer ersten Schicht aus ZnTe oder Zn₁₋ₓMnₓTe beschichtet. Bei dem Substrat handelt es sich vorzugsweise um ein Metallblech oder einer Metallfolie.

Danach wird in Schritt b) diese erste Schicht mit Halogen und Stickstoff dotiert. Dies kann beispielsweise durch eine Behandlung der Schicht unter Stickstoff oder Argon mit Ammoniumhalogenid im Temperaturbereich von 500 bis 1200°C erfolgen. Bei diesen Temperaturen ist Ammoniumhalogenid gasförmig und teilweise in das nitrierende NH₃ und das halogenierende HCl dissoziiert.

In Schritt c) erfolgt anschließend das Erzeugen einer p- oder n-Dotierung durch Dotieren mit Donatoratomen oder Akzeptoratomen. Beispielsweise wird die erste Schicht entweder mit Phosphor (beispielsweise aus PCl₃) zum p-Leiter oder mit Aluminium (beispielsweise aus AlCl₃) zum n-Leiter dotiert.

In Schritt d) wird sodann die zweite Schicht aus ZnTe oder Zn₁₋ₓMnₓTe auf der ersten Schicht abgeschieden. Dazu kann beispielsweise das gleiche Abscheidungsverfahren wie in Schritt a) dienen.

In Schritt e) wird wie anhand der ersten Schicht für Schritt b) beschrieben Stickstoff sowie Halogen in die zweite Schicht eingebracht.

Die in Schritt f) erzeugte Dotierung ist der in Schritt c) erzeugten Dotierung entgegengesetzt, so dass eine Schicht eine p-Dotierung und die andere Schicht eine n-Dotierung aufweist.

Schließlich werden in Schritt g) eine elektrisch leitfähige transparente Schicht und eine Schutzschicht auf die zweite Schicht aufgebracht. Die elektrisch leitfähige transparente Schicht kann beispielsweise eine Schicht aus Indium-Zinn-Oxid oder Aluminium-ZinkOxid sein. Sie trägt ferner vorzugsweise Leiterbahnen für die elektrische Kontaktierung der erfindungsgemäßen photovoltaischen Zelle. Die Schutzschicht ist vorzugsweise eine SiOₓ-Schicht mit x = 1 bis 2.

### Beispiel 1

In ein Quarzrohr mit 10 mm Durchmesser und 200 mm Länge wurden 5,16 g Zn, 1,01 g Mn sowie 12,76 g Te, alle Elemente mit einer Reinheit größer als 99,995 % eingewogen. Das Quarzrohr wurde evakuiert und unter Vakuum abgeschmolzen. Sodann wurde es in einem Rohrofen unter Kippen um die Längsachse (Periode ca. 90 s) innerhalb von 20 h auf 1,250°C gebracht, 5 h bei dieser Temperatur belassen und der Ofen sodann abkühlen gelassen. Es wurde ein Schmelzkörper der Zusammensetzung Zn_{0,8}Mn_{0,2}Te erhalten, der im optischen Reflexionsspektrum eine Bandlücke bei 2,28 eV aufwies.

Zur Dotierung mit Halogenionen und Stickstoffionen wurden 1,8 g dieses Materials zusammen mit 16 mg Ammoniumchlorid in ein anderes Quarzrohr eingewogen. Das Quarzrohr wurde unter Vakuum zugeschmolzen. Es wurde in einem waagrecht angeordneten Rohrofen innerhalb von 5 h auf 900°C erhitzt. Danach wurde der Ofen ausgeschaltet. Die so erhaltene Probe erhielt 0,45 At % N sowie 2,0 At % Cl⁻. Sie zeigt bei 1,380 nm eine zusätzliche Absorption, die einer Energie von 0,9 eV als Zwischenniveau entspricht.

### Beispiel 2

Zum elektrochemischen Abscheiden wurden Elektrolysen in einem 500 ml Planschliff-Reaktionsgefäß mit Doppelmantel, Innenthermometer und Bodenablassventil durchgeführt. Als Kathode wurde ein Edelstahlblech (100 x 70 x 0.5) verwendet. Die Anode bestand aus MKUSF04 (Graphit).

### a) Darstellung von ZnTe

Es wurden 21,35 g ZnSO₄ • 7H₂O und 55,4 mg Na₂TeO₃ in destilliertem Wasser gelöst. Diese Lösung wurde mit H₂SO₄ (2 mol/l) auf pH 2 eingestellt und mit destilliertem Wasser auf 500 ml aufgefüllt (Zn = 0.15 mol/l; Te = 0,5 mmol/l; Zn/Te = 300/1). Anschließend wurde die Elektrolyt-Lösung in die Elektrolysezelle gefüllt und auf 80°C geheizt. Die Elektrolyse wurde über einen Zeitraum von 30 min. bei einem Strom von 100,0 mA ohne Rühren durchgeführt. Die Abscheidung erfolgte bei einer Kathodenfläche von ∼50 cm² (2 mA/cm²). Nach beendeter Elektrolyse wurde die Kathode ausgebaut, mit destilliertem Wasser gespült und getrocknet. Es wurde ein kupferfarbener Film abgeschieden (18,6 mg).

### b) Darstellung von Zn₁₋ₓMnₓTe

Es wurden 21,55 g ZnSO₄ • 7H₂O (0,15 mol/l), 47,68 g MnSO₄ • H₂O (0,6 mol/l), 33 g (NH₄)₂SO₄ (0,5 mol/l), 1 g Weinsäure und 55,4 mg Na₂TeO₃ (0,5 mmol/l) in destilliertem Wasser gelöst. Diese Lösung wurde mit H₂SO₄ (2 mol/l) auf pH 2 eingestellt und mit destilliertem Wasser auf 500 ml aufgefüllt (Zn / Mn / Te = 300 / 1200 / 1). Anschließend wurde die Elektrolyt-Lösung in die Elektrolysezelle gefüllt und auf 80°C geheizt. Die Elektrolyse wurde über einen Zeitraum von 60 min. bei einem Strom von 101,3 mA ohne Rühren durchgeführt. Die Abscheidung erfolgte bei einer Kathodenfläche von -50 cm² (∼2 mA/cm²). Nach beendeter Elektrolyse wurde die Kathode ausgebaut, mit destilliertem Wasser gespült und getrocknet. Die Gewichtszunahme beträgt 26,9 mg. Die Abscheidung hat eine tief dunkelbraune Farbe.

## Patentansprüche

1. Photovoltaische Zelle mit einem photovoltaisch aktiven Halbleitermaterial, **dadurch gekennzeichnet, dass** das photovoltaisch aktive Halbleitermaterial ein p- oder ein n-dotiertes Halbleitermaterial mit einer binären Verbindung der Formel (I) oder mit einer ternären Verbindung der Formel (II) ist:
ZnTe (I)
Zn₁₋ₓMnₓTe (II)
mit x = Zahl von 0,01 bis 0,99,
wobei in dem photovoltaisch aktiven Halbleitermaterial zu einem bestimmten Anteil Tellurionen durch Halogenionen und Stickstoffionen substituiert sind und die Halogenionen ausgewählt sind aus der Gruppe bestehend aus Fluorid, Chlorid und Bromid oder einer Mischung daraus.

2. Photovoltaische Zelle gemäß Anspruch 1, **dadurch gekennzeichnet, dass** in dem photovoltaisch aktiven Halbleitermaterial Stickstoff und Halogene jeweils mit einem Atomkonzentrationsanteil von 0,1 At-% bis 20 At-% enthalten sind.

3. Photovoltaische Zelle gemäß einem der Ansprüche 1 oder 2, **dadurch gekennzeichnet, dass** das p-dotierte Halbleitermaterial mindestens ein Element aus der Gruppe As und P mit einem Atomkonzentrationsanteil von bis zu 0,5 At-% enthält und dass das n-dotierte Halbleitermaterial mindestens ein Element aus der Gruppe Al, In und Ga mit einem Atomkonzentrationsanteil von bis zu 0,5 At-% enthält.

4. Photovoltaische Zelle gemäß einem der Ansprüche 1 bis 3, umfassend ein elektrisch leitfähiges Substrat, eine p-Schicht aus dem p-dotierten Halbleitermaterial mit einer Dicke von 0,1 bis 10 µm und eine n-Schicht aus dem n-dotierten Halbleitermaterial mit einer Dicke von 0,1 bis 10 µm.

5. Photovoltaische Zelle gemäß Anspruch 4, **dadurch gekennzeichnet, dass** das in der n-Schicht enthaltene n-dotierte Halbleitermaterial eine Zusammensetzung gemäß (III) oder (IV) hat:
ZnTe_{1-2y}Hal_{y}N_{y} (III)
Zn₁₋ₓMnₓTe_{1-2y}Hal_{y}N_{y} (IV)
mit x = 0,01 bis 0,99 und y = 0,01 bis 0,2,
und mit Phosphor, Arsen oder einer Mischung daraus dotiert ist und dass das in der p-Schicht enthaltene p-dotierte Halbleitermaterial eine Zusammensetzung gemäß Formel (V) oder (VI) hat:
ZnTe_{1-2y}Hal_{y}N_{y} (V)
Zn₁₋ₓMn_{xT}e_{1-2y}Hal_{y}N_{y} (VI)
mit x = 0,01 bis 0,99 und y = 0,01 bis 0,2,
und mit Aluminium, Indium, Gallium oder einer Mischung daraus dotiert ist.

6. Verfahren zur Herstellung einer photovoltaischen Zelle gemäß einem der Ansprüche 1 bis 5, **gekennzeichnet durch** das Beschichten eines elektrisch leitfähigen Substrats mit mindestens zwei Schichten aus dem p- oder n-dotierten Halbleitermaterial mit der Verbindung nach Formel (I) oder (II), wobei jede Schicht eine Dicke von 0,1 bis 10 µm aufweist.

7. Verfahren gemäß Anspruch 6, **dadurch gekennzeichnet, dass** das Beschichten mindestens ein Abscheidungsverfahren ausgewählt aus der Gruppe Sputtern, elektrochemisches Abscheiden oder stromloses Abscheiden umfasst.

8. Verfahren gemäß Anspruch 7, **dadurch gekennzeichnet, dass** zum Sputtern
i) Sputtertargets aus Zn₁₋ₓMnₓTe:Al und Zn₁₋ₓMnₓTe:P durch Zusammenschmelzen von Bestandteilen hergestellt werden oder
ii) einzelne Bestandteile des Halbleitermaterials nacheinander auf das Substrat gesputtert werden und anschließend auf eine Temperatur von 400 bis 900°C erwärmt werden.

9. Verfahren gemäß Anspruch 7, **dadurch gekennzeichnet, dass** zum stromlosen Abscheiden eine wässrige Lösung, die Zn²⁺-, Mn²⁺- und TeO₃²⁻-Ionen enthält, bei einer Temperatur von 30 bis 90°C mit hypohosphoriger Säure H₃PO₂ als Reduktionsmittel in Gegenwart des Substrats vernetzt wird.

10. Verfahren gemäß einem der Ansprüche 7 bis 9, **gekennzeichnet durch** die Verfahrensschritte:
a) Beschichten des elektrisch leitfähigen Substrats mit einer ersten Schicht aus Zn₁₋ₓMnₓTe oder ZnTe,
b) Dotieren der ersten Schicht mit Halogenionen und Stickstoffionen,
c) Erzeugen einer p- oder einer n-Dotierung **durch** Dotieren mit Donatoratomen oder Akzeptoratomen,
d) Beschichten der ersten Schicht mit einer zweiten Schicht aus Zn₁₋ₓMnₓTe oder ZnTe,
e) Dotieren der zweiten Schicht mit Halogenionen und Stickstoffionen,
f) Erzeugen einer n- oder p-Dotierung **durch** Dotieren mit Akzeptoratomen oder Donatoratomen und
g) Aufbringen einer elektrisch leitfähigen transparenten Schicht und einer Schutzschicht auf die zweite Schicht.

## Claims

1. A photovoltaic cell comprising a photovoltaically active semiconductor material, wherein the photovoltaically active semiconductor material is a p- or n-doped semiconductor material comprising a binary compound of the formula (I) or a ternary compound of the formula (II);
ZnTe (I)
Zn₁₋ₓMnₓTe (II)
where x is from 0.01 to 0.99,
and a particular proportion of tellurium ions in the photovoltaically active semiconductor material has been replaced by halogen ions and nitrogen ions and the halogen ions are selected from the group consisting of fluoride, chloride and bromide and mixtures thereof.

2. The photovoltaic cell according to claim 1, wherein nitrogen and halogens are each present at an atomic concentration of from 0.1 atom% to 20 atom% in the photovoltaically active semiconductor material.

3. The photovoltaic cell according to either claim 1 or 2, wherein the p-doped semiconductor material comprises at least one element from the group consisting of As and P at an atomic concentration of up to 0.5 atom% and the n-doped semiconductor material comprises at least one element from the group consisting of Al, In and Ga at an atomic concentration of up to 0.5 atom%.

4. The photovoltaic cell according to any of claims 1 to 3 comprising an electrically conductive substrate, a p layer of the p-doped semiconductor material having a thickness of from 0.1 to 10 µm and an n layer of the n-doped semiconductor material having a thickness of from 0.1 to 10 µm.

5. The photovoltaic cell according to claim 4, wherein the n-doped semiconductor material present in the n layer has a composition corresponding to (III) or (IV):
ZnTe_{1-2y}Hal_{y}N_{y} (III)
Zn₁₋ₓMnₓTe_{1-2y}Hal_{y}N_{y} (IV)
where x = 0.01 to 0.99 and y = 0.01 to 0.2,
and is doped with phosphorus, arsenic or a mixture thereof and the p-doped semiconductor material present in the p layer has a composition corresponding to the formula (V) or (VI):
ZnTe_{1-2y}Hal_{y}N_{y} (V)
Zn₁₋ₓMnₓTe_{1-2y}Hal_{y}N_{y} (VI)
where x = 0.01 to 0.99 and y = 0.01 to 0.2,
and is doped with aluminum, indium, gallium or a mixture thereof.

6. A process for producing a photovoltaic cell according to any of claims 1 to 5, wherein an electrically conductive substrate is coated with at least two layers of the p- or n-doped semiconductor material comprising the compound of the formula (I) or (II), with each layer having a thickness of from 0.1 to 10 µm.

7. The process according to claim 6, wherein the coating process comprises at least one deposition process selected from the group consisting of sputtering, electrochemical deposition and electroless deposition.

8. The process according to claim 7, wherein
i) sputtering targets of Zn₁₋ₓMnₓTe:Al and Zn₁₋ₓMnₓTe: P are produced by melting constituents together or
ii) individual constituents of the semiconductor material are sputtered successively onto the substrate and are subsequently heated to a temperature of from 400 to 900°C,
for the purpose of sputtering.

9. The process according to claim 7, wherein electroless deposition is effected by crosslinking an aqueous solution comprising Zn²⁺, Mn²⁺ and TeO₃²⁺ ions by means of hypophosphorous acid H₃PO₂ as reducing agent at a temperature of from 30 to 90°C in the presence of the substrate.

10. The process according to any of claims 7 to 9 which comprises the process steps:
a) coating of the electrically conductive substrate with a first layer of Zn₁₋ₓMnₓTe or ZnTe,
b) doping of the first layer with halogen ions and nitrogen ions,
c) establishment of p- or n-doping by doping with donor atoms or acceptor atoms,
d) coating of the first layer with a second layer of Zn₁₋ₓMnₓTe or ZnTe,
e) doping of the second layer with halogen ions and nitrogen ions,
f) establishment of n- or p-doping by doping with acceptor atoms or donor atoms and
g) application of an electrically conductive transparent layer and a protective layer to the second layer.

## Revendications

1. Pile photovoltaïque contenant un matériau semi-conducteur à action photovoltaïque, **caractérisée en ce que** le matériau semi-conducteur à action photovoltaïque est un matériau semi-conducteur à dopage p ou n contenant un composé binaire de formule (I) ou un composé ternaire de formule (II) :
ZnTe (I)
Zn₁₋ₓMnₓTe (II)
avec x = nombre de 0,01 à 0,99,
les ions tellure dans le matériau semi-conducteur à action photovoltaïque étant remplacés en une proportion déterminée par des ions halogène et des ions azote, et les ions halogène étant choisis dans le groupe constitué par fluorure, chlorure et bromure ou un de leurs mélanges.

2. Pile photovoltaïque selon la revendication 1, **caractérisée en ce que** l'azote et les halogènes sont chacun contenus dans le matériau semi-conducteur à action photovoltaïque en une concentration atomique de 0,1 %a à 20 %a.

3. Pile photovoltaïque selon l'une quelconque des revendications 1 ou 2, **caractérisée en ce que** le matériau semi-conducteur à dopage p contient au moins un élément du groupe As et P en une concentration atomique de jusqu'à 0,5 %a, et **en ce que** le matériau semi-conducteur à dopage n contient au moins un élément du groupe Al, In et Ga en une concentration atomique de jusqu'à 0,5 %a.

4. Pile photovoltaïque selon l'une quelconque des revendications 1 à 3, comprenant un substrat conducteur électrique, une couche p du matériau semi-conducteur à dopage p d'une épaisseur de 0,1 à 10 µm et une couche n du matériau semi-conducteur à dopage n d'une épaisseur de 0,1 à 10 µm.

5. Pile photovoltaïque selon la revendication 4, **caractérisée en ce que** le matériau semi-conducteur à dopage n contenu dans la couche n a une composition selon (III) ou (IV) :
ZnTe₁₋₂yHal_{y}N_{y} (III)
Zn₁₋ₓMnₓTe_{1-2y}Hal_{y}N_{y} (IV)
avec x = 0,01 à 0,99 et y = 0,01 à 0,2,
et est dopé avec du phosphore, de l'arsenic ou un de leurs mélanges, et **en ce que** le matériau semi-conducteur à dopage p contenu dans la couche p a une composition selon la formule (V) ou (VI) :
ZnTe_{1-2y}Hal_{y}N_{y} (V)
Zn₁₋ₓMnₓTe_{1-2y}Hal_{y}N_{y} (VI)
avec x = 0,01 à 0,99 et y = 0, 01 à 0,2,
et est dopé avec de l'aluminium, de l'indium, du gallium ou un de leurs mélanges.

6. Procédé de fabrication d'une cellule photovoltaïque selon l'une quelconque des revendications 1 à 5, **caractérisé par** le revêtement d'un substrat conducteur électrique avec au moins deux couches du matériau semi-conducteur à dopage p ou n contenant le composé de formule (I) ou (II), chaque couche présentant une épaisseur de 0,1 à 10 µm.

7. Procédé selon la revendication 6, **caractérisé en ce que** le revêtement comprend au moins un procédé de dépôt choisi dans le groupe constitué par la pulvérisation, le dépôt électrochimique ou le dépôt sans courant.

8. Procédé selon la revendication 7, **caractérisé en ce que** pour la pulvérisation,
i) des cibles de pulvérisation en Zn₁₋ₓMnₓTe:Al et Zn₁₋ₓMnₓTe:P sont fabriquées par fusion de constituants ou
ii) les constituants individuels du matériau semi-conducteur sont pulvérisés les uns après les autres sur le substrat, puis portés à une température de 400 à 900 °C.

9. Procédé selon la revendication 7, **caractérisé en ce que**, pour le dépôt sans courant, une solution aqueuse contenant des ions Zn²⁺, Mn²⁺ et TeO₃²⁻est réticulée à une température de 30 à 90 °C avec de l'acide hypophosphoreux H₃PO₂ en tant que réducteur en présence du substrat.

10. Procédé selon l'une quelconque des revendications 7 à 9, **caractérisé par** les étapes de procédé suivantes :
a) le revêtement du substrat conducteur électrique avec une première couche de Zn₁₋ₓMnₓTe ou ZnTe,
b) le dopage de la première couche avec des ions halogène et des ions azote,
c) la formation d'un dopage p ou n par dopage avec des atomes donneurs ou des atomes accepteurs,
d) le revêtement de la première couche avec une seconde couche de Zn₁₋ₓMnₓTe ou ZnTe,
e) le dopage de la seconde couche avec des ions halogène et des ions azote,
f) la formation d'un dopage p ou n par dopage avec des atomes donneurs ou des atomes accepteurs, et
g) l'application d'une couche transparente conductrice électrique et d'une couche de protection sur la seconde couche.
